# EUROPÄISCHE PATENTANMELDUNG

(11) **EP 0 907 110 A2**
(43) Veröffentlichungstag der Anmeldung: **07.04.1999**
(21) Anmeldenummer: 98118395.7
(22) Anmeldetag: 29.09.1998
(51) Int. Cl.: G03F 7/11

(54) **Mehrschichtelement zur Herstellung von Druck- oder Reliefformen**

(30) Priorität: 01.10.1997 DE 19743507
(71) Anmelder: BASF Drucksysteme GmbH, 48165 Münster (DE)
(72) Erfinder: Blum, Rainer, 67069 Ludwigshafen (DE); Philipp, Sabine, Dr., 64546 Mörfelden-Walldorf (DE); Leinenbach, Alfred, 67161 Gönnheim (DE)
(74) Vertreter: Isenbruck, Günter, Dr.

(57) **Zusammenfassung**

Mehrschichtelement mit einem Schichtträger, einer Zwischenschicht und einer photopolymerisierbaren oder photovernetzbaren Schicht in der angegebenen Reihenfolge zur Herstellung von Druck- oder Reliefformen. Die Zwischenschicht enthält ein Copolymerisat aus einem Monomeren (A) der allgemeinen Formel (I) oder (II) und einem copolymerisierbaren Monomeren (B), 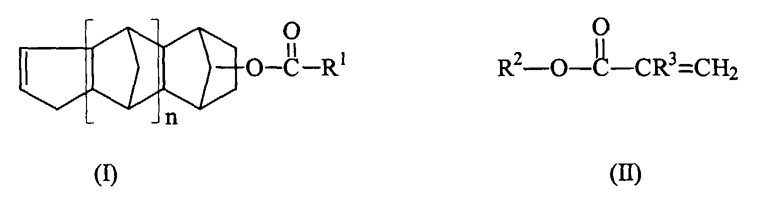 wobei R¹ ein Vinyl-, Propen-2-yl-, 1-Buten-2-yl- oder Styryl-Rest, oder ein Rest R²-O-CO-CH=CH- ist, R² ein Alkyl-, Aryl-, Aralkyl- oder Cycloalkylrest mit bis zu zehn Kohlenstoffatomen, R³ ein H, ein Methyl- oder Ethylrest und n eine Zahl von Null bis 5 ist.

Die Zwischenschicht in dem Mehrschichtelement hat eine verbesserte Verbundhaftung. Sie ist zunächst klebfrei und wird erst nach dem Aufbringen der photopolymerisierbaren Schicht durch die entstehende Wechselwirkung mit dieser klebrig. Die verbesserte Verbundhaftung bleibt auch nach Lagerung und mehrfacher Verwendung der fertigen Druckplatten erhalten.

## Beschreibung

Die Erfindung betrifft ein Mehrschichtelement zur Herstellung von Druck-oder Reliefformen, mit einem Schichtträger, einer haftvermittelnden Zwischenschicht und einer photopolymerisierbaren oder photovernetzbaren Schicht in der angegebenen Reihenfolge.

Mehrschichtelemente zur Herstellung von Druck- oder Reliefformen weisen im allgemeinen photopolymerisierbare oder photovernetzbare Schichten auf, die mit formstabilen Schichtträgern aus Metall- oder Kunststoffolien fest verbunden sind. Die photopolymerisierbare Schicht enthält im allgemeinen ein polymeres Bindemittel, eine polymerisierbare ethylenisch ungesättigte Verbindung sowie einen Initiator, der bei Bestrahlen mit aktinischem Licht die Polymerisation der ethylenisch ungesättigten Verbindung einzuleiten vermag, und gegebenenfalls ein Lichthofschutzmittel, das auch in einer separaten Schicht enthalten sein kann. Ein Negativ wird auf die photopolymerisierbare Schicht aufgebracht und belichtet. Die belichteten Stellen der Schicht werden unlöslich, nichtbelichtete Stellen werden mit einem geeigneten Lösungsmittel ausgewaschen. Es wird eine Reliefdruckform erhalten. Derartige Druckformen sind bekannt und werden u. a. in der DE-A 21 38 582 oder der US 4,459,348 beschrieben.

Beispielsweise beschreibt die US 4,459,348 solche Mehrschichtelemente mit einer haftvermittelnden Zwischenschicht zwischen Träger und photopolymerisierbarer Schicht. Die photopolymerisierbare Schicht ist eine Mischung aus einem elastomeren Bindemittel, das ein Zweiblockcopolymerisat des Typs A-B, ein Dreiblockcopolymerisat des Typs A-B-A mit beispielsweise thermoplastischen Styrolpolymerisatblöcken A und elastomeren Butadien- oder Isopren-Polymerisatblöcken B, oder elastomere Dreiblockcopolymerisate des Typs A-B-C, wie sie auch in der DE-A 29 42 183 als Bindemittel beschrieben werden und einem mit dem elastomeren Bindemittel verträglichen, photopolymerisierbaren, ethylenisch ungesättigten Monomeren, wie zum Beispiel Ester der Acrylsäure mit ein- oder mehrwertigen Alkoholen und einem geeigneten Photopolymerisationsinitiator. Außerdem können weitere Zusatzstoffe, wie thermische Polymerisationsinhibitoren enthalten sein. Die haftvermittelnde Zwischenschicht zwischen dem Träger und der photopolymerisierbaren Schicht besteht aus einem mit Polyisocyanat gehärteten und vernetzten hydroxylgruppenhaltigen Polyurethanharz oder Polyesterharz, einem Polyetherharz, hydroxylgruppenhaltigen Epoxidharz oder bevorzugt einem hydroxylgruppenhaltigen Phenoxyharz. Mit den beschriebenen haftvermittelnden Zwischenschichten wird zwar eine deutliche Verbesserung der Haftung in Mehrschichtelementen erreicht, in der Praxis geht die Haftung bei der Lagerung jedoch verloren.

Die DE-A 22 12 090 beschreibt ebenfalls Mehrschichtelemente zur Herstellung von Reliefformen. Die dort verwendeten lichtempfindlichen Massen weisen eine Oberflächenklebrigkeit auf. Eine separate, haftvermittelnde Zwischenschicht wird nicht beschrieben.

Die DE-A 29 42 183 betrifft photopolymerisierbare Gemische für die Herstellung von Reliefformen für den Flexodruck, die Dreiblockcopolymere A-B-C als Bindemittel enthalten. Beim Belichten von solchen photopolymerisierbaren, Acrylsäure- oder Methacrylsäureester enthaltenden Druckplatten tritt unter Sauerstoffzutritt eine Oberflächenklebrigkeit auf, die zur Haftvermittlung ausgenutzt und durch klebrigmachende Zusätze, wie Kohlenwasserstoffharze, Polyterpene, Cumaron-Inden Harze u. ä., verstärkt werden kann. Als vorteilhaft wird eine elastomere Unterschicht unter der photopolymerisierbaren Schicht angesehen, die aus dem gleichen Material wie diese besteht und durch Weichmacherzusätze auf eine dem Druckverhalten angepaßte Härte eingestellt werden kann. Die Unterschicht kann durch Totalbelichtung photovernetzt werden.

In der nicht-vorveröffentlichten, älteren DE-A 196 00 155 werden polyfunktionell reaktive polymere Stoffe, die Struktureinheiten des Dihydrodicyclopentadiens oder von dessen Oligomeren enthalten, beschrieben, wobei diese Struktureinheiten beispielsweise über Ether-, Ester-, Urethan-, Amid-, Keton- oder C-C-Bindungen mit der Polymerhauptkette verknüpft sind. Diese Polymerisate eigenen sich als Bindemittel für unterschiedliche Anwendungen.

In der nicht-vorveröffentlichten, älteren DE-A 197 07 478 werden ungesättigte Polyester mit Struktureinheiten, die Reste aus Dihydrodicyclopentadien und ungesättigten Dicarbonsäuren oder deren Anhydriden enthalten, beschrieben. Diese ungesättigten Polyester werden als Tränk- und Überzugslösungen verwendet.

Die nicht-vorveröffentlichte, ältere DE-A 197 07 492 beschreibt Polyesterharzmassen oder -lösungen, die ungesättigte oder gesättigte Polyester aus Struktureinheiten mit Resten des Dihydrodicyclopentadiens enthalten und die zum Beschichten von Formkörpern eingesetzt werden.

Aufgabe der vorliegenden Erfindung ist es, Mehrschichtelemente zur Herstellung von Druck- und Reliefformen zur Verfügung zu stellen, die eine Zwischenschicht mit verbesserter Verbundhaftung enthalten sollen. Die Zwischenschicht soll klebfrei sein und nach dem Aufbringen der reliefbildenden Schicht durch die entstehenden Wechselwirkungen klebrig werden. Die Verbundhaftung soll nach Lagerung und mehrfacher Verwendung der fertigen Druckformen erhalten bleiben.

Die Erfindung geht aus von einem Mehrschichtelement aus einem Schichtträger, einer Zwischenschicht und einer photopolymerisierbaren oder photovernetzbaren Schicht in der angegebenen Reihenfolge, zur Herstellung von Druck- oder Reliefformen. Das erfindungsgemäße Mehrschichtelement ist dadurch gekennzeichnet, daß die Zwischenschicht ein Copolymerisat aus einem Monomeren (A) der allgemeinen Formel (I) oder (II) und einem copolymerisierbaren Monomeren (B) enthält, 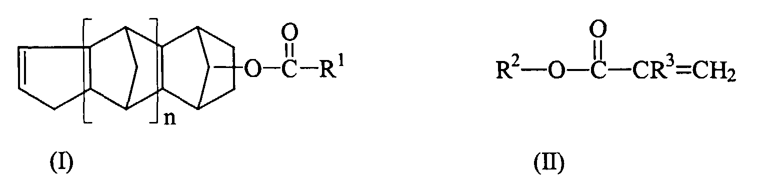 wobei R¹ ein Vinyl-, Propen-2-yl-, 1-Buten-2-yl- oder Styryl-Rest oder ein Rest R²-O-CO-CH=CH- ist, R² ein Alkyl-, Aryl-, Aralkyl- oder Cycloalkylrest mit bis zu zehn Kohlenstoffatomen, R³ ein H, Methyl- oder Ethylrest und n eine Zahl von Null bis 5, bevorzugt Null oder 1 ist.

Als Monomer (A) wird ein Dihydrodicyclopentadienylderivat der Formel (I) eingesetzt, bevorzugt Dihydrodicyclopentadienylacrylat, Dihydrodicyclopentadienylmethacrylat, Dihydrodicyclopentadienylethacrylat, Dihydrodicyclopentadienylcinnamat, Dihydrodicyclopentadienylmonomaleinat, Dihydrodicyclopentadienylmonofumarat, Bis(dihydrodicyclopentadienyl)maleinat, Bis(dihydrodicyclopentadienyl)fumarat, insbesondere Dihydrodicyclopentadienylacrylat oder Dihydrodicyclopentadienylmethacrylat.

Der Dihydrodicyclopentadienylester der Formel (I) mit n = 0 bis 5 wird durch Addition von Dicyclopentadien an die ungesättigte Säure R₁-COOH hergestellt. Beispielsweise wird Dihydrodicyclopentadienylacrylat durch Addition des entsprechenden Dicyclopentadiens an Acrylsäure hergestellt.

Dihydrodicyclopentadienylreste mit n = 0 bis 5 werden bevorzugt in situ aus Cyclopentadien bzw. Dicyclopentadien durch eine Pfropfreaktion gebildet bei Temperaturen oberhalb 130°C, bevorzugt oberhalb 170°C.

Als Monomer (A) kann auch bevorzugt ein Acrylat der allgemeinen Formel (II) eingesetzt werden. Dabei werden Acrylate bevorzugt, die ein Homopolymeres mit einem T_{g}-Wert >30°C bilden. Ein Copolymerisat aus solchen Acrylaten besitzt erst oberhalb der Raumtemperatur eine klebrige Eigenschaft, oder erfindungsgemäß in Wechselwirkung mit anderen Schichten. Besonders bevorzugt werden Methylmethacrylat und tert. Butylacrylat eingesetzt.

Das Copolymerisat enthält Einheiten des Comonomers (B), welches der allgemeinen Formel (III) oder (IV) entspricht,

R¹-CO-OR⁴ (III)

>

R¹-CO-NR⁵R⁶ (IV)

wobei R⁴ H, ein gegebenenfalls substituierter Alkylrest mit 1 bis 30 Kohlenstoffatomen, oder ein alicyclischer, araliphatischer oder heterocyclischer Rest ist und R⁵ und R⁶ untereinander gleich oder verschieden sind und H, Hydroxyalkyl oder Alkyl mit 1 bis 30 Kohlenstoffatomen oder Alkoxymethyl mit bis zu 12 Kohlenstoffatomen bedeuten. Wenn R⁴ ein substituierter Alkylrest ist, kann dieser eine polymerisierbare oder vernetzbare Gruppe enthalten. Einheiten des Comonomers (B) der allgemeinen Formel (III) werden bevorzugt eingesetzt, insbesondere Methylmethacrylat oder Butylacrylat.

Das Copolymerisat kann zur Modifizierung seiner Härte Einheiten von Monomeren (B) enthalten, die einen für diesen Zweck geeigneten T_{g}-Wert aufweisen und zu einem Anteil von 0 bis 10% im Copolymerisat einpolymerisiert sein können. Als hartmachende Verbindung kann u. a. eine vinylaromatische Verbindung, beispielsweise Styrol, oder als weichmachende Verbindungen können Ethylhexylacrylat, n-Butylacrylat, Dodecylacrylat oder Tridecylacrylat eingesetzt werden

Zwischenschichten für die erfindungsgemäßen Mehrschichtelemente werden vorzugsweise mit Copolymerisaten erhalten, die 5 bis 30% des Monomers (A), 60 bis 95% Comonomer (B), zu einem Anteil von 0 bis 10% eine weitere Verbindung mit polymerisierbaren ethylenisch ungesättigten Resten zur Modifizierung der Härte des Copolymers.

Eine besonders bevorzugte Ausführungsform des Copolymerisats enthält 10 bis 25% Einheiten des Comonomers (A), 65 bis 90% Einheiten des Comonomers (B) und 0 bis 10% Einheiten der hart- oder weichmachenden Verbindung.

Die Copolymere zur Herstellung der beschriebenen Zwischenschicht werden in an sich bekannter Weise durch radikalische Lösungspolymerisation erhalten. Das Molekulargewicht der Copolymere kann durch dem Fachmann bekannte Reaktionsbedingungen, wie die Auswahl geeigneter Lösungsmittel, Art und Menge der Radikalstarter und der möglicherweise mitverwendeten Polymerisationsregler, in einem bestimmten Bereich gesteuert werden. Vorzugsweise wird der Polymerisationsgrad auf K-Werte zwischen 10 und 80, besonders bevorzugt zwischen 15 und 30 eingestellt.

Für den Aufbau der Zwischenschicht in dem erfindungsgemäßen Mehrschichtelement aus Polyacrylatharzen wird diese bevorzugt aus Lösung oder Dispersion auf die Träger appliziert und dann zu klebfreien Schichten getrocknet. Die klebfreien polymeren Zwischenschichten werden nach dem Aufbringen der reliefbildenden Schicht durch eine Wechselwirkung mit dieser Schicht haftklebrig und bilden somit einen stabilen Verbund. Dieser Wechsel von klebfrei zu klebrig ermöglicht es, Trägermaterialien mit der Zwischenschicht zu beschichten und diese dann aufgerollt zwischenzulagern, ohne das sie verkleben und zu einem späteren Zeitpunkt die reliefbildende Schicht aufzubringen.

Mehrschichtelemente, die die beschriebene Zwischenschicht enthalten, können im übrigen aus starren oder flexiblen Trägern und harten bis hochelastischen photopolymerisierbaren oder photovernetzbaren Schichten aufgebaut sein. Es kann zweckmäßig sein, die Elastizität der Zwischenschicht an die Gesamtelastizität des Mehrschichtelementes anzupassen.

Zur Modifizierung der Härte können ferner als hartmachende Verbindungen ungesättigte Kohlenwasserstoffharze (z. B. Escopol®- und Escorez®-Harze der Firma ESSO) oder als weichmachende Verbindungen ungesättigte Öle, Fette, Fettsäuren oder Fettsäureester dem Copolymerisat zugemischt werden.

Mindestens eine Schicht des Mehrschichtelementes kann ein Lichthofschutzmittel enthalten. Als Lichthofschutzmittel kommen UV-Licht absorbierende Stoffe wie beispielsweise Michlers Keton und dessen Derivate in Frage.

Die Herstellung der photopolymerisierbaren oder photovernetzbaren Schichten erfolgt in bekannter Weise. Dabei kommen elastomere oder harte photopolymerisierbare oder photovernetzbare Schichten in Frage. Die photopolymerisierbaren oder photovernetzbaren Schichten können in bekannter Weise Hilfsstoffe wie z. B. Photoinitiatoren, Polymerisationsinhibitoren, Farbstoffe, photochrome Stoffe, Antioxidantien, oberflächenaktive Stoffe, Viskositätsregulatoren oder Weichmacher enthalten. Die photopolymerisierbaren oder photovernetzbaren Schichten werden auf übliche Träger aus Polyester, Aluminium oder Stahl aufgebracht. Diese Schichtträger können zusätzlich oberflächenbehandelt sein, beispielsweise durch Coronaentladung, chemisches Ätzen oder mechanisches Anrauhen.

Bekannte Herstellverfahren sind beispielsweise das aufeinanderfolgende Gießen der Zwischenschichten und der photopolymerisierbaren oder photovernetzbaren Schicht aus Lösungen auf den Träger, oder die Beschichtung des Trägers mit der Zwischenschicht und späterer Auftrag der photopolymerisierbaren oder photovernetzbaren Schicht aus Lösung oder als extrudierbare Masse.

Die bevorzugte Applikationsform der Zwischenschicht ist das Gießen aus Lösung. Die Zwischenschicht hat dabei eine Dicke von 2 bis 50µm, bevorzugt 5 bis 20µm, insbesondere 5 bis 10 µm.

In den nachfolgenden Beispielen werden Lösungen zur Herstellung einer erfindungsgemäßen haftvermittelnden Zwischenschicht dargestellt. Die angegebenen Mengenangaben entsprechen Gewichtsteilen (T), Prozente und Mengenverhältnisse sind in Gewichtseinheiten angegeben.

### Beispiel 1:

In einem Kolben mit Rührvorrichtung, der mit einem Thermometer, einem Rückflußkühler und zwei Zulaufgefäßen versehen war, wurden je 240 T Essigsäureethylester und Isopropanol vorgelegt. Das erste Zulaufgefäß enthielt eine Mischung aus:
190 T Butylacrylat
100 T Dihydrodicyclopentadienylacrylat
190 T Styrol
20 T Acrylsäure
und das zweite Zulaufgefäß enthielt eine Lösung aus:
120 T Methylisopropylketon
30 T Benzoylperoxid

Die Vorlage wurde auf ca. 80°C geheizt. Bei Erreichen der Temperatur wurde mit der Zugabe des Inhalts der beiden Zulaufgefäße gleichzeitig begonnen, wobei der Inhalt von Zulauf 1 innerhalb von 2 Stunden zugegeben wurde und der Inhalt von Zulauf 2 innerhalb von 2,5 Stunden. Die Mischung wurde anschließend eine Stunde lang bei 80°C gehalten. Anschließend wurde das Lösungsmittel abdestilliert und der Rückstand in Tetrahydrofuran aufgenommen, bis eine 10%ige Lösung erhalten wurde.

### Beispiel 2:

Die Reaktion wurde analog zu Beispiel 1 durchgeführt, mit dem Unterschied, daß das erste Zulaufgefäß folgende Mischung enthielt:
190 T Butylacrylat
50 T Methylmethacrylat
240 T Styrol
20 T Acrylsäure

### Beispiel 3:

Die Reaktion wurde analog zu Beispiel 1 durchgeführt, mit dem Unterschied, daß das erste Zulaufgefäß folgende Mischung enthielt :
190 T Butylacrylat
50 T tert. Butylacrylat
240 T Styrol
20 T Acrylsäure

### Vergleichsbeispiel :

Für die Vergleichstests wurde ein Haftlack verwendet, der in der EP-B 0 055 807 beschrieben wird und folgende Zusammensetzung hat:

75 T Phenoxyharz (PKHH® der Firma Union Carbide Corp.) und 25 T Polycarbonat (Makrolon 2800® der Firma BAYER AG) wurden in 900 T Tetrahydrofuran gelöst. Unmittelbar vor der Verwendung wurden dieser Lösung 35 T eines Polyisocyanats (Desmodur L® der Firma BAYER AG) zugemischt.

### Beispiel 4:

40 T einer Lösung nach Beispiel 1 wurden mit 60 T einer Lösung des Vergleichsbeispiels vermischt. Die resultierende Lösung ist für die Bildung der Zwischenschicht geeignet und weist eine höhere Lösemittelbeständigkeit auf als Beispiel 1.

Die photopolymerisierbare Schicht ist in der DE-A 2 942 183 beschrieben worden und wurde in einer Knetvorrichtung als homogene Mischung aus folgenden Bestandteilen hergestellt:
85 T ABC Blockcopolymer [A: Polystyrol, B: Polyisopren,
C: Poly(Styrol/Butadien)]
5 T Hexandioldiacrylat
2 T Trimethylolpropantriacrylat
1 T Benzildimethylketal
1 T 2,6-Di-tert.-butyl-p-kresol
5 T dünnflüssiges Paraffinöl (Weißöl)

### Herstellung der Prüfmuster:

Die in den Beispielen 1 bis 4 beschriebenen Lösungen und das Vergleichsbeispiel lagen als 10%ige Haftlacklösung in Tetrahydrofuran vor. Auf einer kontinuierlich arbeitenden Technikumsanlage wurden auf 125µm starke Polyethylenterephtalatfolie die Lösungen der Beispiele und des Vergleichsbeispiels für die Zwischenschicht mit einem Durchlaufgießer in einer Schichtdicke von 20µm aufgebracht. Die so beschichteten Folien wurden im Heißluftkanal bei 130°C zwei Minuten getrocknet. Die Beschichtungen hatten anschließend eine Schichtdicke von ca. 5 µm, waren nicht klebrig und konnten aufgerollt werden. Auch nach zwei Monaten Lagerzeit ließen sich die Folien ohne zu verkleben von der Rolle abwickeln.

Nach einer Woche Zwischenlagerung wurde auf die mit den Haftlacken vorbeschichteten Folien die oben beschriebene photopolymerisierbare Mischung mit einem Breitschlitzextruder bei 130°C aufextrudiert und unmittelbar nach der Extrudierung mit einem Walzenkalander zusammengepreßt.

### Prüfung der Haftfestigkeit:

Der hergestellte Verbund wurde ca. 15 Minuten mit UV-A-Licht (Intensitätsmaximum bei einer Wellenlänge von ca. 360 nm und einer Leistung von 40 Watt) bestrahlt. Es wurden 2 cm breite Streifen von den bestrahlten Verbunden geschnitten und an einem Ende die Folie von der reliefbildenden Schicht abgetrennt. Die aufgetrennten Enden des Streifens wurden in ein Zugmeßgerät eingespannt und in einem Winkel von 90° die Haftkraft in N/cm zwischen Haftlack und photopolymerisierbarer Schicht gemessen.

| Test Haftkraft [N/cm] | Beispiel | | | | |
|---|---|---|---|---|---|
| | 1 | 2 | 3 | 4 | Vergleich |
| sofort nach Extrusion | 4,3 | 1,8 | 2,9 | 4,8 | 3,8 |
| 1 Tag nach Extrusion | 7,7 | 4,7 | 5,3 | 7,3 | 4,6 |
| 10 Tage nach Extrusion | 7,7 | 5,1 | 7,0 | 6,8 | 4,1 |
| 100 Tage nach Extrusion | 8,2 | 4,9 | 6,4 | 7,7 | 0,7 |

Die Klebrigkeit wurde durch manuellen Fingertest an der freigelegten Zwischenschicht eines unbelichteten Verbundes beurteilt

| Test Klebrigkeit | Beispiel | | | | |
|---|---|---|---|---|---|
| | 1 | 2 | 3 | 4 | Vergleich |
| sofort nach Extrusion | leicht | leicht | leicht | klebfrei | klebfrei |
| | klebrig | klebrig | klebrig | | |
| 1 Tag nach Extrusion | stark | stark | stark | klebrig | klebfrei |
| | klebrig | klebrig | klebrig | | |
| 10 Tage nach Extrusion | stark | stark | stark | stark | klebfrei |
| | klebrig | klebrig | klebrig | klebrig | |
| 100 Tage nach Extrusion | stark | stark | stark | stark | klebfrei |
| | klebrig | klebrig | klebrig | klebrig | |

## Patentansprüche

1. Mehrschichtelement mit einem Schichtträger, einer Zwischenschicht und einer photopolymerisierbaren oder photovernetzbaren Schicht in der angegebenen Reihenfolge zur Herstellung von Druck- oder Reliefformen, dadurch gekennzeichnet, daß die Zwischenschicht ein Copolymerisat aus einem Monomeren (A) der allgemeinen Formel (I) oder (II) und einem copolymerisierbaren Monomeren (B) enthält, 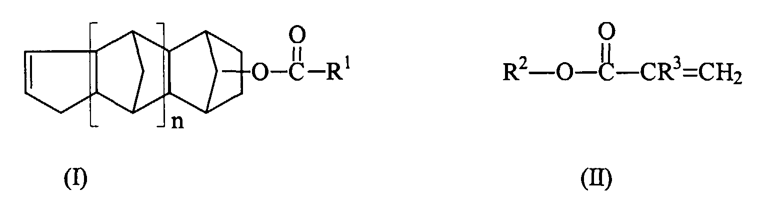 wobei R¹ ein Vinyl-, Propen-2-yl-, 1-Buten-2-yl- oder Styryl-Rest, oder ein Rest R²-O-CO-CH=CH- ist, R² ein Alkyl-, Aryl-, Aralkyl- oder Cycloalkylrest mit bis zu zehn Kohlenstoffatomen, R³ ein H, ein Methyl-oder Ethylrest und n eine Zahl von Null bis 5 ist.

2. Mehrschichtelement nach Anspruch 1, dadurch gekennzeichnet, daß das Monomere der allgemeinen Formel (II) ein Homopolymeres mit einem T_{g}-Wert >30°C bildet.

3. Mehrschichtelement nach Anspruch 1 oder 2, dadurch gekennzeichnet, daß n Null oder 1 ist.

4. Mehrschichtelement nach Anspruch 1, dadurch gekennzeichnet, daß das Comonomer (B) der allgemeinen Formel (III) oder (IV) entspricht,
R¹-CO-OR⁴ (III)
R¹-CO-NR⁵R⁶ (IV)
wobei R⁴ H, ein gegebenenfalls substituierter Alkylrest mit 1 bis 30 Kohlenstoffatomen, oder ein alicyclischer, araliphatischer oder heterocyclischer Rest ist und R⁵ und R⁶ untereinander gleich oder verschieden sind und H, Alkyl mit 1 bis 30 Kohlenstoffatomen oder Alkoxymethyl mit bis zu 12 Kohlenstoffatomen bedeuten.

5. Mehrschichtelement nach Anspruch 1 dadurch gekennzeichnet, daß R⁴ ein substituierter Alkylrest ist, der eine polymerisierbare oder vernetzbare ethylenisch ungesättigte Gruppe enthält.

6. Mehrschichtelement nach Anspruch 1, dadurch gekennzeichnet, daß das Comonomere (B) Reste zur Modifizierung seiner Härte enthält.

7. Mehrschichtelement nach Anspruch 1, dadurch gekennzeichnet, daß die Zwischenschicht zusätzlich Verbindungen zur Modifizierung der Härte des Copolymerisats enthält.

8. Mehrschichtelement nach Anspruch 1, dadurch gekennzeichnet, daß die Zwischenschicht eine Dicke von 2 bis 50µm, bevorzugt 5 bis 20µm hat.

9. Mehrschichtelement nach Anspruch 1, dadurch gekennzeichnet, daß die photopolymerisierbare Schicht ein polymeres Bindemittel, eine polymerisierbare ethylenisch ungesättigte Verbindung und einen Photoinitiator enthält, der bei Bestrahlung mit aktinischem Licht die Polymerisation der ethylenisch ungesättigten Verbindung einzuleiten vermag.
